# EUROPEAN PATENT APPLICATION

(11) **EP 1 995 347 A1**
(43) Date of publication of application: **26.11.2008**
(21) Application number: 06782219.7
(22) Date of filing: 27.07.2006
(51) Int. Cl.: C23C 16/18, H01L 21/285

(54) **METHOD OF FORMING METAL FILM**

(30) Priority: 08.02.2006 JP 2006031334
(71) Applicant: JSR Corporation, Tokyo 104-0045 (JP)
(72) Inventor: SAKAI, Tatsuya, Tokyo 104-0045 (JP); MATSUKI, Yasuo, Tokyo 104-0045 (JP); KAWAGUCHI, Kazuo, Tokyo 104-0045 (JP)
(74) Representative: TBK-Patent
(86) International application number: PCT/JP2006/315359
(87) International publication number: WO 2007/091339

(57) **Abstract**

A method of forming a metal film, comprising the steps of:
sublimating at least one metal compound selected from the group consisting of a cobalt compound, a ruthenium compound and a tungsten compound from a substrate having the above metal compound film formed thereon; and
supplying the sublimated gas to a substrate for forming a metal film to decompose the gas, thereby forming a metal film on the surface of the first substrate.

A method of forming a metal film which serves as a seed layer when a metal, especially copper is to be filled into the trenches of a substrate as an insulator by plating and as a barrier layer for preventing the migration of metal atoms to an insulating film when the substrate has no barrier layer and has excellent adhesion to the insulator.

## Description

### TECHNICAL FIELD

The present invention relates to a method of forming a cobalt, ruthenium or tungsten metal film. More specifically, it relates to a method of forming a metal film suitable for use as a seed layer for filling copper into a trench by plating.

### BACKGROUND ART

Wiring and electrode structures are becoming finer and more complex to achieve higher performance in the field of electronic devices such as DRAM's (Dynamic Random Access Memories), and the shapes of these structures are desired to be more accurate.

To form electrodes and wirings in an electronic device, in general, a trench is formed in a portion where a wiring or electrode should be formed of a substrate, a metal material which should become the wiring or electrode is filled into the trench, and a surplus metal is removed by chemical mechanical polishing or the like.

Copper which has an advantage such as high conductivity has been widely used as an electrode material or a wiring material to be filled in the trench. When copper is used as the material, a physical method such as deposition or sputtering, or a plating method has been used to fill copper into the trench.

When the physical method such as deposition or sputtering is used to fill copper into a trench, the width of the opening of the trench becomes small and the when the aspect ratio of the trench (a value obtained by dividing the depth of the trench by the minimum distance of the opening on the surface of the trench) is large, copper deposited in an area near the opening of the trench closes the opening of the trench, whereby a void (a portion where copper is not filled) may be formed in the trench.

Meanwhile, the plating method has an advantage that copper can be filled into a trench having a large aspect ratio and a small opening width at a high rate (refer to JP-A 2000-80494 and JP-A 2003-318258). However, when a substrate having trenches is an insulator having no conductivity (for example, a substrate made of silicon oxide), a conductive film (seed layer) which should be a base film for plating must be formed on the surface of the substrate prior to plating. Copper has been often used to form this conductive film for sputtering or electroless plating.

There is known a phenomenon that copper atoms migrate from a copper layer to an insulator when the insulator typified by silicon oxide and copper contact with each other. When the migration of the copper atoms occurs at the interface between copper and the insulator in an electronic device, the electric properties of the device are impaired.
Therefore, when copper is used as a material to be filled into the trenches of the electronic device and as a seed layer to fill copper into the trenches by sputtering or electroless plating, a barrier layer must be formed between the insulator and the seed layer. Tantalum, titanium, tantalum nitride or titanium nitride is often used as the material of the barrier layer. However, since adhesion between these materials for the barrier layer and copper is unsatisfactory, an electronic device having a laminate structure consisting of an insulator, a barrier layer and copper has a low production yield and lacks reliability.

### DISCLOSURE OF THE INVENTION

It is an object of the present invention which has been made in view of the above situation to provide a method of easily forming a film which serves as a seed layer when a metal such as copper is to be filled into the trenches of a substrate as an insulator by plating and as a barrier layer for preventing the migration of metal atoms to an insulating film when the substrate has no barrier layer and has excellent adhesion to the insulator and a film which has excellent adhesion to a barrier layer when the substrate has the barrier layer.

According to the present invention, firstly, the above object of the present invention can be attained by a method of forming a metal film, comprising the steps of:
sublimating at least one metal compound selected from the group consisting of a cobalt compound, a ruthenium compound and a tungsten compound from a second substrate carrying the above metal compound onto a first substrate for forming a film thereon of at least one metal selected from cobalt, ruthenium and tungsten; and
supplying the sublimated gas to the first substrate to decompose the gas, thereby forming a metal film on the surface of the first substrate.

Secondly, the above object of the present invention is attained by a method of forming a metal film, comprising the steps of:
opposing a first substrate for forming a film thereon of at least one metal selected from the group consisting of cobalt, ruthenium and tungsten to a second substrate having a film of at least one metal compound selected from the group consisting of a cobalt compound, a ruthenium compound and a tungsten compound;
sublimating the metal compound on the second substrate; and
supplying the sublimated gas to the first substrate to decompose the gas, thereby forming a metal film on the surface of the first substrate.

According to the present invention, thirdly, the above object of the present invention is attained by a method of forming a metal film, comprising the steps of:
forming a film of at least one metal compound selected from the group consisting of a cobalt compound, a ruthenium compound and a tungsten compound on a substrate for forming a film thereon of at least one metal selected from the group consisting of cobalt, ruthenium and tungsten;
sublimating the metal compound; and
supplying the sublimated gas to a portion different from a portion from which the metal compound has been sublimated of the substrate to decompose the gas, thereby forming a metal film on the surface of the substrate.

### BRIEF DESCRIPTION OF THE DRAWING

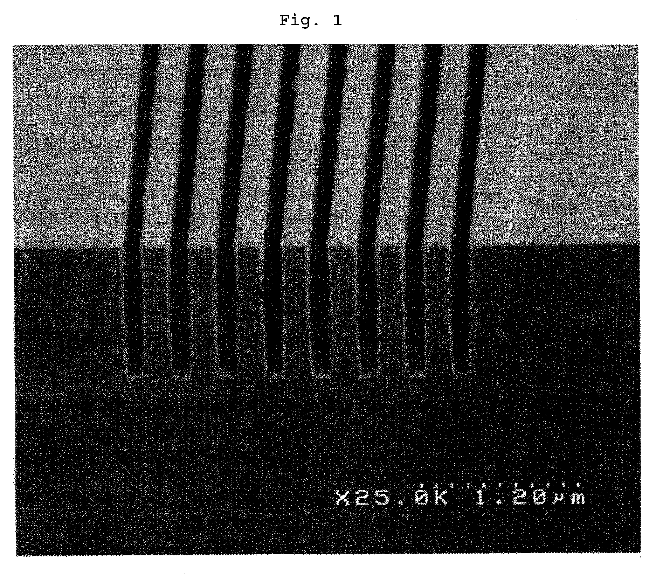

Fig. 1 is an electron microphotograph of a substrate having trenches after the cobalt film obtained in Example 2 is formed.

### BEST MODE FOR CARRYING OUT THE INVENTION

The first method out of the methods of the present invention is characterized in that at least one metal compound selected from the group consisting of a cobalt compound, a ruthenium compound and a tungsten compound is sublimated from a second substrate carrying the above metal compound onto a first substrate for forming a film thereon of at least one metal selected from the group consisting of cobalt, ruthenium and tungsten, and the sublimated gas is supplied to the first substrate to decompose the gas, thereby forming a metal film on the surface of the first substrate.

The second method out of the methods of the present invention is characterized in that a substrate for forming a film thereon of at least one metal selected from the group consisting of cobalt, ruthenium and tungsten is opposed to a second substrate having a film of at least one metal compound selected from the group consisting of a cobalt compound, a ruthenium compound and a tungsten compound, the metal compound on the second substrate is sublimated, and the sublimated gas is supplied to the substrate for forming a metal film to decompose the gas, thereby forming a metal film on the surface of the substrate.

Examples of the material constituting the substrate on which the above metal film is to be formed include glasses, metals, metal nitrides, silicon, resins and insulating films.

The above glasses include quartz glass, boric acid glass, soda glass and lead glass.

The above metals include gold, silver, copper, nickel, aluminum and iron.

The above metal nitrides include titanium nitride, tantalum nitride and tungsten nitride.

The above resins include polyethylene terephthalate, polyimide and polyether sulfone.

The above insulating films include silicon oxide, titanium oxide, zirconium oxide, hafnium oxide, tantalum oxide and niobium oxide films, insulating film called "SOG" and insulating film having a low dielectric constant formed by CVD.

Examples of the above silicon oxide film include a thermally oxidated film, PETEOS (Plasma Enhanced TEOS) film, HDP (High Density Plasma Enhanced TEOS) film, BPSG (boron phosphorus silicate) film and FSG (Fluorine Doped Silicate Glass) film.

The above thermally oxidated film is formed by exposing silicon to a high-temperature oxidizing condition. The PETEOS film is formed from tetraethyl orthosilicate (TEOS) by chemical vapor deposition making use of plasma as a promoter. The HDP film is formed from tetraethyl orthosilicate (TEOS) by chemical vapor deposition making use of high-density plasma as a promoter. The BPSG film can be obtained by normal-pressure CVD or vacuum CVD. The FSG film is formed by chemical vapor deposition making use of high-density plasma as a promoter.

The above "SOG" stands for Spin on Glass and refers to an insulating film having a low dielectric constant obtained by applying a liquid composition prepared by dissolving or dispersing a silicon compound as a precursor in an organic solvent to a substrate by spin coating and heating the coating film. The silicon compound as a precursor is, for example, silsesquioxane. Commercially available products of the insulating film called "SOG" include Coral (of Nuvellus Systems Inc.), Aurola (of ASM Japan K.K.), Nanoglass (of Honeywell International Inc.) and LKD (of JSR Corporation).

Out of the above materials for the substrate, the silicon oxide film, the insulating film called "SOG" and the insulating film having a low dielectric constant formed by CVD are preferred, the silicon oxide film is more preferred, and the PETEOS film, BPSG film and FSG film are much more preferred.

The above substrate may have a barrier layer on the surface. Examples of the material constituting the barrier layer include tantalum, titanium, tantalum nitride and titanium nitride. Out of these, tantalum and tantalum nitride are preferred.

When the substrate on which the metal film is to be formed has trenches, the advantageous effect of the present invention is exhibited more markedly. The trenches are formed in the substrate made of the above material by a known method, for example, photolithography.

Although the trench may have any shape or size, when the opening width of the trench (the minimum distance of a portion open to the surface of the substrate) is 10 to 300 nm and the aspect ratio of the trench (a value obtained by dividing the depth of the trench by the opening width of the trench) is 3 or more, the advantageous effect of the present invention is exhibited to the maximum. The opening width of the above trench may be 10 to 200 nm, specifically 10 to 100 nm, most specifically 10 to 50 nm. The aspect ratio of the above trench may be 3 to 40, specifically 5 to 25.

The second substrate which can be used in the above first method is not particularly limited if it has a container structure that can store a predetermined amount of the metal compound, allows for the diffusion of a gas generated by the sublimation of the metal compound and can stand heating for sublimation. The same material as the first substrate on which the above metal film is to be formed may be used.

The shape of the second substrate is not particularly limited but preferably a shape that enables the stable supply of the gas generated by the sublimation of the above metal compound or a shape having a face mated with at least part of a portion (face) where the metal film of the substrate on which the metal film is to be formed is formed. Particularly preferably, the shape is dish-like, boat-like or box-like with an open top.

The above expression "a second substrate carrying the above metal compound" means that the metal compound preferably in a solid form is left on the second substrate.

The second substrate which can be used in the above second method is not particularly limited if it enables the film of the above metal compound to be formed by coating and stands heating for sublimating the metal compound. The same material as that of the substrate on which the above metal film is to be formed may be used.

The shape of the second substrate is not particularly limited but preferably a shape having a face mating with at least part of a portion (face) where the metal film of the substrate on which the metal film is to be formed is formed.

To form the film of the metal compound on the surface of the second substrate described above, a composition containing the metal compound and a solvent is applied to the second substrate and then the solvent is removed.

Although any cobalt compound may be used to form a cobalt film as the above metal film if it can sublime, a cobalt compound having at least one selected from a CO ligand and a π-coordinate ligand is preferred.

This cobalt compound is, for example, a compound represented by any one of the following formulas (1) to (5).

L1_{c}Co(CO)_{d}Yₑ (1)

(L¹ is a group represented by the following formula (1)-1:

(CH₃)ₙCp (1)-1

(Cp is a η⁵-cyclopentadienyl group and n is an integer of 0 to 5),
indenyl group or a ligand selected from 1,3-cyclooctadiene, 1,4-cyclooctadiene, 1,5-cyclooctadiene, 1,3-butadiene, norbornadiene and propylene, Y is a halogen atom, hydrogen atom, methyl group or ethyl group, c is 1 or 2, d is 0, 1, 2 or 4, and e is 0 or 2, with the proviso that (c + d + e) is 2, 3, 4, or 5, and when c is 2, two L¹'s may be the same or different)

L²_{f}(Co₂(CO)_{g}Rₕ (2)

(L² is defined the same as L' in the above formula (1)-1 or a ligand selected from 1,3-cyclohexadiene, 1,4-cyclohexadiene, propylene, norbornadiene and cyclooctene, R is a halogen atom, PhC:::CPh (::: means a triple bond), CCH₃, CH₃, CH₂, CH or CPh, f is 0, 1, 2 or 4, g is 1, 2, 4, 6 or 8, and h is 0, 1 or 2, with the proviso that (f + g + h) is 4, 6, 7 or 8)

Co₃(CO₉)CZ (3)

(Z is a halogen atom)

Co₃(CO)₁₂ (4)

Co₄(CO)₁₂ (5)

Examples of the complex represented by the formula (1) include cyclopentadienyldicarbonyl cobalt,
cyclopentadienylcarbonyl cobalt difluoride,
cyclopentadienylcarbonyl cobalt dichloride,
cyclopentadienylcarbonyl cobalt dibromide,
cyclopentadienylcarbonyl cobalt diiodide,
bis(cyclopentadienyl)cobalt,
bis(cyclopentadienyl)carbonyl cobalt,
bis(cyclopentadienyl)dicarbonyl cobalt,
methylcyclopentadienyldicarbonyl cobalt,
methylcyclopentadienylcarbonyl cobalt difluoride,
methylcyclopentadienylcarbonyl cobalt dichloride,
methylcyclopentadienylcarbonyl cobalt dibromide,
methylcyclopentadienylcarbonyl cobalt diiodide,
bis(methylcyclopentadienyl)cobalt,
bis(methylcyclopentadienyl)carbonyl cobalt,
bis(methylcyclopentadienyl)dicarbonyl cobalt,
tetramethylcyclopentadienyldicarbonyl cobalt,
tetramethylcyclopentadienylcarbonyl cobalt difluoride,
tetramethylcyclopentadienylcarbonyl cobalt dichloride,
tetramethylcyclopentadienylcarbonyl cobalt dibromide,
tetramethylcyclopentadienylcarbonyl cobalt diiodide,
bis(tetramethylcyclopentadienyl)cobalt,
bis(tetramethylcyclopentadienyl)carbonyl cobalt,
bis(tetramethylcyclopentadienyl)dicarbonyl cobalt,
1,5-cyclooctadienedicarbonyl cobalt,
1,5-cyclooctadienecarbonyl cobalt difluoride,
1,5-cyclooctadienecarbonyl cobalt dichloride,
1,5-cyclooctadienecarbonyl cobalt dibromide,
1,5-cyclooctadienecarbonyl cobalt diiodide,
bis(1,5-cyclooctadiene)cobalt,
bis(1,5-cyclooctadiene)carbonyl cobalt,
1,3-cyclooctadienedicarbonyl cobalt,
1,3-cyclooctadienecarbonyl cobalt difluoride,
1,3-cyclooctadienecarbonyl cobalt dichloride,
1,3-cyclooctadienecarbonyl cobalt dibromide,
1,3-cyclooctadienecarbonyl cobalt diiodide,
bis(1,3-cyclooctadiene)cobalt,
bis(1,3-cyclooctadiene)carbonyl cobalt, indenyldicarbonyl cobalt, indenylcarbonyl cobalt difluoride, indenylcarbonyl cobalt dichloride, indenylcarbonyl cobalt dibromide, indenylcarbonyl cobalt diiodide, bis(indenyl)cobalt,
bis(indenyl)carbonyl cobalt, η³-allyltricarbonyl cobalt,
η³-allylcarbonyl cobalt difluoride, η³-allylcarbonyl cobalt dichloride, η³-allylcarbonyl cobalt dibromide,
η³-allylcarbonyl cobalt diiodide, bis(η³-allyl)carbonyl cobalt, cyclopentadienyl(1,5-cyclooctadiene)cobalt, cyclopentadienyl(tetramethylcyclopentadienyl)cobalt, tetramethylcyclopentadienyl(1,5-cyclooctadiene)cobalt, cyclopentadienyl(methylcyclopentadienyl)cobalt, methylcyclopentadienyl(tetramethylcyclopentadienyl) cobalt, methylcyclopentadienyl(1,5-cyclooctadiene)cobalt, cyclopentadienyl(1,3-cyclooctadiene)cobalt, tetramethylcyclopentadienyl(1,3-cyclooctadiene)cobalt, methylcyclopentadienyl(1,3-cyclooctadiene)cobalt, cyclopentadienyl(cyclooctatetraenyl)cobalt, cyclopentadienyl(1,3-butadiene)cobalt, cyclopentadienyl(norbornadiene)cobalt, cyclopentadienylcarbonyl cobalt dihydride, methylcyclopentadienylcarbonyl cobalt dihydride, tetramethylcyclopentadienylcarbonyl cobalt dihydride, methyltetracarbonyl cobalt and ethyltetracarbonyl cobalt.

Examples of the complex represented by the above formula (2) include bis(cyclopentadienyl)dicarbonyl dicobalt, bis(tetramethylcyclopentadienyl)dicarbonyl dicobalt, octacarbonyl dicobalt, (norbornene)hexacarbonyl dicobalt, bis(cyclopentadienyl)dimethyldicarbonyl dicobalt, tetra(η³-allyl)dicobalt diiodide, bis(1,3-cyclohexadienyl)tetracarbonyl dicobalt, bis(norbornene)tetracarbonyl dicobalt, bis(cyclopentadienyl)dicarbonyl dicobalt and complexes represented by the following formulas (i) to (v).

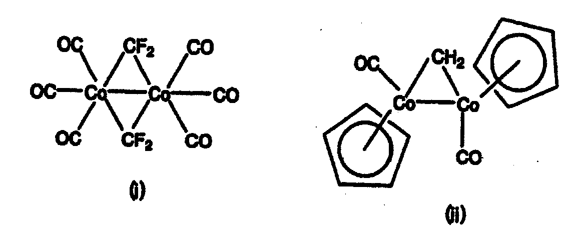

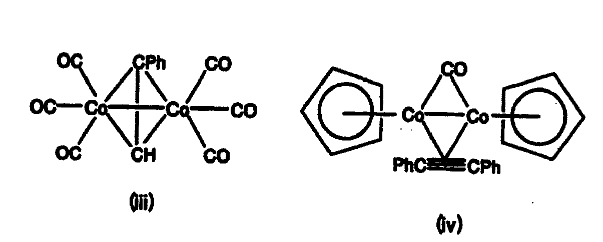

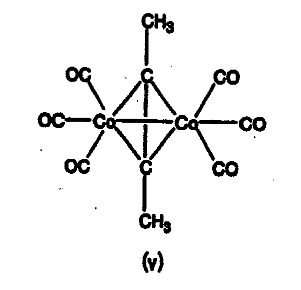

The complex represented by the above formula (3) is, for example, a complex represented by the following formula (vi).

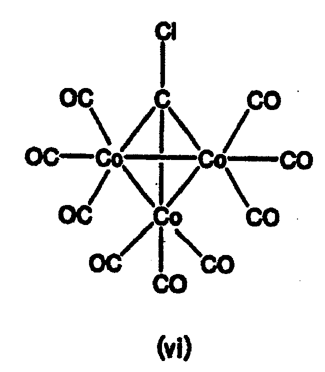

Out of these, bis(cyclopentadienyl)cobalt,
bis(tetracyclopentadienyl)cobalt,
bis(1,3-cyclooctadiene)cobalt,
bis(1,5-cyclooctadiene)cobalt, bis(indenyl)cobalt,
cyclopentadienyldicarbonyl cobalt,
methylcyclopentadienyldicarbonyl cobalt,
tetramethylcyclopentadienyldicarbonyl cobalt,
(1,3-cyclooctadiene)dicarbonyl cobalt,
(1,5-cyclooctadiene)dicarbonyl cobalt, indenyldicarbonyl cobalt, η³-allyltricarbonyl cobalt
cyclopentadienyl(1,3-cyclooctadiene)cobalt,
cyclopentadienyl(1,5-cyclooctadiene)cobalt,
cyclopentadienyl(indenyl)cobalt,
indenyl(1,3-cyclooctadiene)cobalt,
indenyl (1,5-cyclooctadiene) cobalt or octacarbonyl dicobalt is preferably used.

These cobalt compounds may be used alone or in combination of tow or more.

Any ruthenium compound may be used to form a ruthenium film as the above metal film if it can sublime. A ruthenium compound having at least one selected from a CO ligand and a π-coordinate ligand is preferred.

Examples of the ruthenium compound include compounds represented by the following formulas (6) to (10). 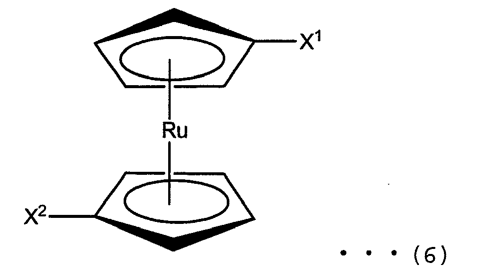 (X¹ and X² are each independently a hydrogen atom, hydrocarbon group having 1 to 8 carbon atoms, fluorine atom, trifluoromethyl group, pentafluoroethyl group or a group represented by the following formula (6)-1: 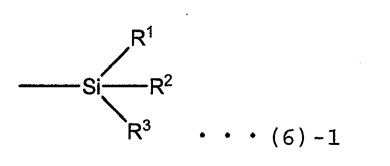 (R¹, R² and R³ are each independently a hydrocarbon group having 1 to 10 carbon atoms) , with the proviso that both X¹ and X² cannot be a hydrogen atom at the same time)

Ru(OCOR⁴)₃ (7)

(R⁴ is a trifluoromethyl group or hydrocarbon group having 1 to 10 carbon atoms, and three R₄'s may be the same or different)

YRu(CO)₃ (8)

(Y is a cyclopentadienyl group, cyclohexadiene, cycloheptadiene, cyclooctadiene, butadiene or 2,3-dimethyl-1,3-butadiene)

YRuHₙLₘ (9)

(Y is as defined in the above formula (8), L is a carbonyl group, methyl group or ethenyl group, n is an integer of 1 to 4, and m is an integer of 0 to 2, with the proviso that n + m = 3 or 4 and when m is 2, two L's may be the same or different)

Ruₗ(CO)ₒ (10)

(l is an integer of 1 to 9, and o is an integer of 1 to 50)

In the above formula (6), it should be understood that the cyclopentadienyl group having X¹ or X² is η⁵-coordinated. X¹ or X² is preferably a hydrogen atom, hydrocarbon group having 1 to 8 carbon atoms, trifluoromethyl group or a group represented by the following formula (6)-1: 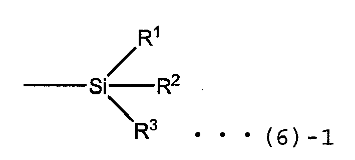 (R¹, R² and R³ are each independently a hydrocarbon group having 1 to 10 carbon atoms), preferably a hydrogen atom, methyl group, ethyl group, propyl group, isopropyl group, t-butyl group, trifluoromethyl group, trimethylsilyl group, triethylsilyl group or tri-n-butoxysilyl group.

In the above formula (7), R⁴ is a hydrocarbon group having 1 to 10 carbon atoms or trifluoromethyl group, preferably an alkyl group having 1 to 8 carbon atoms or trifluoromethyl group, more preferably methyl group, ethyl group, 2-ethylhexyl group or trifluoromethyl group.

In the above formulas (8) and (9), Y is a cyclopentadienyl group, cyclohexadiene, cycloheptadiene, cyclooctadiene, butadiene or 2,3-dimethyl-1,3-butadiene. It should be understood that the cyclopentadienyl group is η⁵-coordinated and that the other groups represented by Y are coordinated by non-conjugated 4 electrons.

Y is preferably a cyclopentadienyl group, 1,3-cyclohexadiene, 1,4-cyclohexadiene, 1,3-cyclooctadiene, 1,4-cyclooctadiene or 2,3-dimethyl-1,3-butadiene. Out of these, Y is more preferably a cyclopentadienyl group, 1,3-cyclohexadiene, 1,4-cyclohexadiene or 2,3-dimethyl-1,3-butadiene, much more preferably a cyclopentadienyl group or 2,3-dimethyl-1,3-butadiene. In the above formula (9), L is a carbonyl ligand, methyl group or ethenyl group, preferably a carbonyl ligand or methyl group, more preferably a carbonyl ligand.

Out of the ruthenium compounds represented by the above formula (6), (7), (8), (9) and (10), the compounds represented by the above formulas (6), (8), (9) and (10) are preferred. The compounds represented by the above formulae include bis(cyclopentadienyl)ruthenium,
bis(ethylcyclopentadienyl)ruthenium,
bis(methylcyclopentadienyl)ruthenium,
bis(t-butylcyclopentadienyl)ruthenium,
bis(trifluoromethylcyclopentadienyl)ruthenium,
1,4-cyclooctadienetricarbonyl ruthenium,
1,3-cyclooctadienetricarbonyl ruthenium,
1,4-cyclohexadienetricarbonyl ruthenium,
1,3-cyclohexadienetricarbonyl ruthenium,
bis(trimethylsilylcyclopentadienyl)ruthenium,
cyclopentadienyl ruthenium tetrahydride,
2,3-dimethyl-1,3-butadiene ruthenium tetrahydride,
cyclopentadienylcarbonyl ruthenium dihydride,
2,3-dimethyl-1,3-butadienecarbonyl ruthenium dihydride,
triruthenium dodecacarbonyl, ruthenium hexacarbonyl, ruthenium tetracarbonyl, diruthenium decacarbonyl and tetraruthenium hexadecacarbonyl.

These compounds may be used alone or in combination of two or more as a chemical vapor deposition material.

Any tungsten compound may be used to form a tungsten film as the above metal film if it can sublime. A tungsten compound having at least one selected from a CO ligand and a π-coordinate ligand is preferred.

Examples of the tungsten compound include a compound represented by the following formula (11).

W(RCN)ₙ(CO)₆₋ₙ (11)

(R is a hydrocarbon group having 1 to 10 carbon atoms or halogenated hydrocarbon group having 1 to 10 carbon atoms, and n is an integer of 0 to 6, with the proviso that when n is an integer of 2 to 6, a plurality of R's may be the same or different)

In the above formula (11), R is a hydrocarbon group having 1 to 10 carbon atoms or halogenated hydrocarbon group having 1 to 10 carbon atoms, preferably a hydrocarbon group having 1 to 8 carbon atoms or halogenated hydrocarbon group having 1 to 6 carbon atoms, more preferably a linear or branched alkyl group having 1 to 8 carbon atoms or haloalkyl group having 1 to 6 carbon atoms. Examples of the hydrocarbon group include methyl group, ethyl group, n-propyl group, i-propyl group, n-butyl group, i-butyl group, t-butyl group, phenyl group, trifluoromethyl group, 1,1,1-trifluoroethyl group, trichloromethyl group and 1,1,1-trichloroethyl group.

In the above formula (11) , n is an integer of 0 to 6, preferably 0 to 4, particularly preferably 0 to 3.

The above tungsten compound is synthesized in accordance with methods disclosed by D. P. Tate, W.R. Knipple and J.M. Augl, Inorganic. Chem., Vol. 1, No. 2 (1962) 433 and W. Strohmeir and G. Schonauer, Chem. Ber., Vol. 94 (1961) 1346.

Examples of the tungsten compound represented by the above formula (11) include hexa(acetonitrile)tungsten,
penta(acetonitrile)carbonyl tungsten,
tetra(acetonitrile)dicarbonyl tungsten,
tri(acetonitrile)tricarbonyl tungsten,
di(acetonitrile)tetracarbonyl tungsten,
(acetonitrile)pentacarbonyl tungsten,
hexa(propionitrile)tungsten, penta(propionitrile)carbonyl tungsten, tetra(propionitrile)dicarbonyl tungsten,
tri(propionitrile)tricarbonyl tungsten,
di(propionitrile)tetracarbonyl tungsten,
(propionitrile)pentacarbonyl tungsten,
hexa(butyronitrile)tungsten, penta(butyronitrile)carbonyl tungsten, tetra(butyronitrile)dicarbonyl tungsten,
tri(butyronitrile)tricarbonyl tungsten,
di(butyronitrile)tetracarbonyl tungsten,
(butyronitrile)pentacarbonyl tungsten,
hexa(isobutyronitrile)tungsten,
penta(isobutyronitrile)carbonyl tungsten,
tetra(isobutyronitrile)dicarbonyl tungsten,
tri(isobutyronitrile)tricarbonyl tungsten,
di(isobutyronitrile)tetracarbonyl tungsten,
(isobutyronitrile)pentacarbonyl tungsten,
hexa(valeronitrile)tungsten, penta(valeronitrile)carbonyl tungsten, tetra(valeronitrile)dicarbonyl tungsten,
tri(valeronitrile)tricarbonyl tungsten,
di(valeronitrile)tetracarbonyl tungsten,
(valeronitrile)pentacarbonyl tungsten,
hexa(trimethylacetonitrile)tungsten,
penta(trimethylacetonitrile)carbonyl tungsten,
tetra(trimethylacetonitrile)dicarbonyl tungsten,
tri(trimethylacetonitrile)tricarbonyl tungsten,
di(trimethylacetonitrile)tetracarbonyl tungsten,
(trimethylacetonitrile)pentacarbonyl tungsten,
hexa(benzonitrile)tungsten, penta(benzonitrile)carbonyl tungsten, tetra(benzonitrile)dicarbonyl tungsten,
tri(benzonitrile)tricarbonyl tungsten,
di(benzonitrile)tetracarbonyl tungsten,
(benzonitrile)pentacarbonyl tungsten,
hexa(trichloroacetonitrile)tungsten,
penta(trichloroacetonitrile)carbonyl tungsten,
tetra(trichloroacetonitrile)dicarbonyl tungsten,
tri(trichloroacetonitrile)tricarbonyl tungsten,
di(trichloroacetonitrile)tetracarbonyl tungsten, (trichloroacetonitrile)pentacarbonyl tungsten and
hexacarbonyl tungsten.

Out of these, tetra(acetonitrile)dicarbonyl tungsten, tri(acetonitrile)tricarbonyl tungsten,
di(acetonitrile)tetracarbonyl tungsten,
tetra(propionitrile)dicarbonyl tungsten,
tri(propionitrile)tricarbonyl tungsten,
di(propionitrile)tetracarbonyl tungsten,
tetra(valeronitrile)dicarbonyl tungsten,
tri(valeronitrile)tricarbonyl tungsten,
di(valeronitrile)tetracarbonyl tungsten,
tetra(trimethylacetonitrile)dicarbonyl tungsten,
tri(trimethylacetonitrile)tricarbonyl tungsten, di(trimethylacetonitrile)tetracarbonyl tungsten and hexacarbonyl tungsten are preferred,
tetra(acetonitrile)dicarbonyl tungsten,
tri(acetonitrile)tricarbonyl tungsten,
di(acetonitrile)tetracarbonyl tungsten,
tri(propionitrile)tricarbonyl tungsten,
tetra(valeronitrile)dicarbonyl tungsten,
tri(valeronitrile)tricarbonyl tungsten,
di(valeronitrile)tetracarbonyl tungsten and hexacarbonyl tungsten are more preferred, and
tri(acetonitrile)tricarbonyl tungsten,
tri(propionitrile)tricarbonyl tungsten,
tetra(valeronitrile)dicarbonyl tungsten,
tri(valeronitrile)tricarbonyl tungsten and hexacarbonyl tungsten are particularly preferred.

These compounds may be used alone or in combination of two or more.

Examples of the solvent used to apply the above cobalt compound include aliphatic hydrocarbons, alicyclic hydrocarbons, aromatic hydrocarbons, alcohols, ethers, ketones and halogenated hydrocarbons.

The above aliphatic hydrocarbons include n-hexane, n-heptane, n-octane, n-nonane and n-decane; the above alicyclic hydrocarbons include cyclohexane, cycloheptane and cyclooctane; the above aromatic hydrocarbons include benzene, toluene and xylene; the above alcohols include methanol, ethanol, propanol, butanol, isopropanol, propylene glycol monomethyl ether and propylene glycol monoethyl ether; the above ethers include diethyl ether, dipropyl ether, dibutyl ether, ethylene glycol dimethyl ether, ethylene glycol diethyl ether, ethylene glycol methyl ethyl ether, diethylene glycol dimethyl ether, diethylene glycol diethyl ether, diethylene glycol methyl ethyl ether, tetrahydrofuran, tetrahydropyran and p-dioxane; the above ketones include acetone, methyl ethyl ketone, cyclohexanone and diethyl ketone; and the above halogenated hydrocarbons include methylene chloride, tetrachloroethane, chloromethane and chlorobenzene.

Out of these, aliphatic hydrocarbons, aromatic hydrocarbons and alcohols are preferred, and hexane, heptane, cyclohexane, toluene and isopropanol are more preferred.

Preferred examples of the solvent for the ruthenium compound include alcohols and ketones, out of which methanol, ethanol, propyl alcohol, butanol, propylene glycol monomethyl ether, propylene glycol monoethyl ether, acetone and methyl ethyl ketone are particularly preferred.

Preferred examples of the solvent for the tungsten compound include alcohols and halogenated hydrocarbons, out of which methanol, ethanol, propyl alcohol, butanol, propylene glycol monomethyl ether, propylene glycol monoethyl ether, methylene chloride, tetrachloroethane and chloromethane are particularly preferred.

The solvents may be used alone or in combination of two or more.

The composition containing the metal compound and the solvent may contain a surfactant, a silane coupling agent or a polymer in addition to the above metal compound and solvent.

The content of the metal compound in the composition containing the metal compound and the solvent is preferably 0.1 to 50 wt%, more preferably 1 to 30 wt%.

The composition containing the metal compound and the solvent is applied to the above second substrate, and the solvent is removed to form a film of the metal compound on the second substrate.

To apply the composition to the second substrate, a suitable method may be used. Examples of the application method which can be employed herein include spin coating, dip coating, curtain coating, roll coating, spray coating, ink jet coating and printing.

After the composition is applied, the solvent is removed. To remove the solvent from the coating film, the coated second substrate is kept at preferably 0 to 100°C, more preferably 10 to 50°C for preferably 0.1 to 60 minutes, more preferably 1 to 20 minutes.

The atmosphere for the above application and the removal of the solvent is preferably an inert gas atmosphere such as nitrogen, argon or helium.

The thickness of the metal compound film formed on the second substrate which should be suitably adjusted according to the thickness of the metal film to be formed is preferably 10 nm to 10 µm, more preferably 100 nm to 5 µm as a value after the removal of the solvent.

Subsequently, the substrate on which the metal film is to be formed and the second substrate having the above metal compound film thereon are arranged for example being opposed to each other. A portion where the metal film is to be formed of the substrate on which the metal film is to be formed and a portion having the metal compound film thereon of the second substrate should be opposed to each other. The distance between the two substrates is preferably 0.1 to 10 mm, more preferably 0.5 to 2 mm.

The metal compound is then sublimated by applying heat radiation to the metal compound film on the second substrate.

A heat source which can be used to apply heat radiation is, for example, a heater, infrared lamp, infrared laser, semiconductor laser or sunlight. It may be radiant heat from the heated substrate on which the metal film is to be formed. Since heat radiation is applied to only a specific portion of the film, the heat radiation may be applied through a mask having a pattern.

The temperature of the above heat radiation treatment should be a temperature at which the metal compound can sublime and should be suitably set according to the type of the metal compound in use. The temperature reaching the surface of the metal compound film on the second substrate is preferably 50°C or higher, more preferably 50 to 500°C, much more preferably 100 to 300°C.

The metal compound which has sublimed from the second substrate is converted into a metal upon its contact with the substrate on which the metal film is to be formed and deposited on the substrate, thereby forming a metal film. The substrate on which the metal film is to be formed is preferably pre-heated. The temperature of the substrate on which the metal film is to be formed should be higher than a temperature at which the metal compound can decompose and should be suitably set according to the type of the metal compound in use but preferably 50 to 100°C.

When the metal compound is a cobalt compound, the temperature of the substrate is preferably 100 to 300°C, more preferably 100 to 250°C, much more preferably 120 to 220°C.

When the metal compound is a ruthenium compound, the above temperature is preferably 90 to 350°C, more preferably 100 to 300°C, much more preferably 100 to 250°C.

When the metal compound is a tungsten compound, the above temperature is preferably 100 to 350°C, more preferably 120 to 300°C, much more preferably 120 to 250°C.

When the metal compound is a mixture of two or three compounds, the temperature range shown in the table below is recommended.

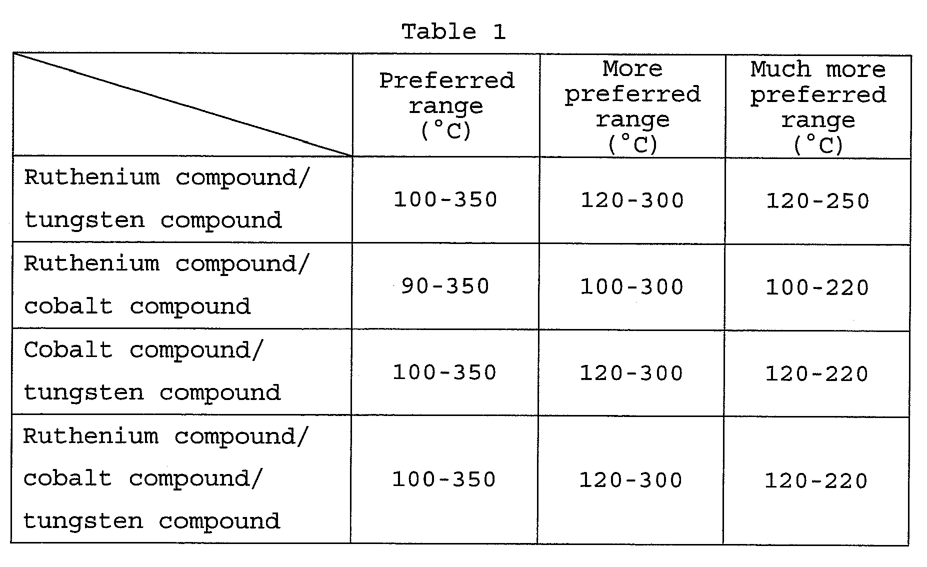

The atmosphere for the sublimation of the metal compound by the application of heat radiation to the second substrate and the decomposition of the metal compound upon contact with the substrate on which the metal film is to be formed from the sublimated product is preferably an inert atmosphere or vacuum. The inert atmosphere can be obtained by an inert gas. Examples of the inert gas include nitrogen, helium and argon. As the atmosphere for the application of heat radiation, the pressure is preferably normal pressure when the inert atmosphere is employed.

The metal film is thus formed on the substrate on which the metal film is to be formed. The thickness of the metal film is preferably 1 to 1,000 nm, more preferably 5 to 100 nm.

In the third method out of the methods of the present invention, the metal compound film is formed on the substrate on which the metal film is to be formed and sublimated, and the sublimated gas is supplied to a portion different from the portion from which the sublimated gas is generated of the substrate to decompose the gas so as to form the metal film on the surface of the substrate.

The substrate on which the metal film is to be formed and which can be used in the third method is the same as in the above first and second methods.

The composition containing the metal compound and the solvent used to form the metal compound film on the substrate, the application method and the method of removing the solvent are the same as when the metal compound film is formed on the second substrate in the above second method.

In the third method, the decomposition of the sublimated gas obtained by sublimating the metal compound from the metal compound film formed on the substrate and supplied to a portion different from the portion from which the sublimated gas is generated of the substrate can be carried out by heating at 100 to 200°C with an infrared lamp or the like for 1 to 60 minutes in an inert gas atmosphere.

As described above, there is provided a method of easily forming a metal film which serves as a seed layer when a metal, especially copper is to be filled into the trenches of a substrate as an insulator by plating and as a barrier layer for preventing the migration of metal atoms into the insulating film and has excellent adhesion to the insulator.

### Examples

### Example 1

### <preparation of a substrate and a composition containing a cobalt compound and a solvent>

A 4 inch-diameter silicon substrate having a 10 nm-thick tantalum nitride film on one side was prepared as a substrate (first substrate) on which a cobalt film was to be formed.

A 4 inch-diameter silicon substrate was prepared as a second substrate.

A solution of 10 g of octacarbonyl dicobalt dissolved in 90 g of isopropyl alcohol was prepared as a composition containing a cobalt compound and a solvent.

The above isopropyl alcohol solution of octacarbonyl dicobalt was applied to one side of the silicon substrate as the second substrate in a nitrogen atmosphere by spin coating and kept at 25°C for 5 minutes to form a 10 µm-thick cobalt compound film.

### <formation of a cobalt film>

Thereafter, the tantalum nitride film side of the first substrate and the cobalt compound film side of the second substrate were opposed to each other at an interval of a 1.0 mm in a nitrogen atmosphere. The back of the first substrate was brought into contact with the surface of a hot place to heat the first substrate at 200 °C. The cobalt compound on the second substrate was heated by radiant heat from the heated first substrate to be sublimated, thereby forming a silver white film on the first substrate. When the SIMS analysis of this film was carried out, it was found that this film was made of metal cobalt. The cobalt film had a thickness of 20 nm and a specific resistance of 12 µΩcm.

### <performance test as a seed layer>

The substrate having the cobalt film formed as described above was plated with copper by using a copper sulfate-based electroplating solution at a plating temperature of 18°C and a plating current of 2.83 A for a plating time of 5 minutes to form a 1.2 µm-thick copper layer on the cobalt film. When a cross-cut adhesion test was made on this copper layer in accordance with JIS K5600-5-6, all of the 100 squares were not removed and the adhesion of the copper layer was extremely high.

### Example 2

An 8 inch-diameter silicon substrate having a tantalum nitride film with a thickness of 10 nm including the inside of each trench on the surface having linear trenches with a width of 150 nm and a depth of 750 nm (aspect ratio of 5) was prepared.

A silver white film was formed on the first substrate in the same manner as the formation of a cobalt layer in Example 1 except that the above silicon substrate was used as a substrate (first substrate) on which a cobalt film was to be formed. When the SIMS analysis of this film was carried out, it was found that this film was made of metal cobalt. This cobalt film had a thickness of 25 nm. This value was obtained by measuring a flat portion excluding the trenches. When the substrate having the cobalt film was cut in a direction perpendicular to the lengthwise direction of the trenches and its section was observed through a scanning microscope, the cobalt film was uniformly formed to the insides of the trenches. This electron microphotograph is shown in Fig. 1.

A 1.2 µm-thick copper layer was formed on the cobalt film of the substrate having trenches and the above cobalt film in the same manner as the performance test as a seed layer in Example 1. The thickness of the copper layer was a value obtained by measuring a flat portion excluding the trenches. When the substrate was cut in the direction perpendicular to the lengthwise direction of the trenches and its section was observed through a scanning electron microscope, no void was seen in the insides of the trenches and trench filling was satisfactory.

### Example 3

### <formation of a ruthenium film>

A 4 inch-diameter silicon substrate having a 10 nm-thick tantalum nitride film on one side was prepared as a substrate on which a ruthenium film was to be formed. 3 g of triruthenium dodecacarbonyl was weighed and placed in a quartz boat-like vessel in a nitrogen atmosphere. Then, the quartz vessel was heated at 150°C. The vapor of the ruthenium compound was generated from the heated vessel and brought into contact with the surface of the substrate heated at 200°C to form a silver white film on the substrate. When the ESCA analysis of this film was carried out, it was found that this film was made of metal ruthenium. This metal ruthenium film had a thickness of 25 nm and a specific resistance of 16 µΩcm.

### <performance test as a seed layer>

The substrate having a ruthenium film formed as described above was plated with copper by using a copper sulfate-based electroplating solution at a plating temperature of 18°C and a plating current of 2.83 A for a plating time of 5 minutes to form a 1.2 µm-thick copper layer on the ruthenium film. When a cross-cut adhesion test was made on this copper layer in accordance with JIS K5600-5-6, all of the 100 squares were not removed and the adhesion of the copper layer was extremely high.

### <formation of ruthenium film on trench substrate>

An 8 inch-diameter silicon substrate having a tantalum nitride film with a thickness of 10 nm including the inside of each trench on the surface having linear trenches with a width of 150 nm and a depth of 750 nm (aspect ratio of 5) was prepared.

A silver white film was formed on the substrate in the same manner as the formation of a ruthenium film described above except that the above silicon substrate was used as a substrate (first substrate) on which a ruthenium film was to be formed. When the ESCA analysis of this film was carried out, it was found that this film was made of metal ruthenium. This metal ruthenium film had a thickness of 32 nm. This value was obtained by measuring a flat portion excluding the trenches. When the substrate having the ruthenium film was cut in a direction perpendicular to the lengthwise direction of the trenches and its section was observed through a scanning microscope, the ruthenium film was uniformly formed to the insides of the trenches.

A 1.2 µm-thick copper layer was formed on the ruthenium film of the substrate having a ruthenium film in the same manner as the performance test as a seed layer described above. The thickness of the copper layer was a value obtained by measuring a flat portion excluding the trenches. When the substrate was cut in the direction perpendicular to the lengthwise direction of the trenches and its section was observed through a scanning electron microscope, no void was seen in the insides of the trenches and trench filling was satisfactory.

### Example 4

### <preparation of a substrate and a composition containing a ruthenium compound and a solvent>

A 4 inch-diameter silicon substrate having a 10 nm-thick tantalum nitride film on one side was prepared as a substrate (first substrate) on which a ruthenium film was to be formed.

A 4-inch diameter silicon substrate was prepared as a second substrate.

A solution of 10 g of triruthenium dodecacarbonyl dissolved in 90 g of acetone was prepared as a composition containing a ruthenium compound and a solvent.

The above acetone solution of triruthenium dodecacarbonyl was applied to one side of the silicon substrate as the second substrate by spin coating in a nitrogen atmosphere and kept at 25°C for 5 minutes to form a 12 µm-thick ruthenium compound film.

### <formation of a ruthenium film>

Thereafter, the tantalum nitride film side of the first substrate and the ruthenium compound film side of the second substrate were opposed to each other at an interval of 1.0 mm in a nitrogen atmosphere. The back of the first substrate was brought into contact with the surface of a hot plate to heat the first substrate at 150°C. The ruthenium compound on the second substrate was heated by radiant heat from the heated first substrate to be sublimated, thereby forming a silver white film on the first substrate. When the ESCA analysis of this film was carried out, it was found that this film was made of metal ruthenium. This metal ruthenium film had a thickness of 30 nm and a specific resistance of 17 µΩcm.

### <performance test as a seed layer>

The substrate having a ruthenium film formed as described above was plated with copper by using a copper sulfate-based electroplating solution at a plating temperature of 18°C and a plating current of 2.83 A for a plating time of 5 minutes to form a 1.2 µm-thick copper layer on the ruthenium film. When a cross-cut adhesion test was made on this copper layer in accordance with JIS K5600-5-6, all of the 100 squares were not removed and the adhesion of the copper layer was extremely high.

### <formation of ruthenium film on trench substrate>

A 8 inch-diameter silicon substrate having a tantalum nitride film with a thickness of 10 nm including the inside of each trench on the surface having linear trenches with a width of 150 nm and a depth of 750 nm (aspect ratio of 5) was prepared.

A silver white film was formed on the first substrate in the same manner as the formation of a ruthenium film described above except that the above silicon substrate was used as a substrate (first substrate) on which a ruthenium film was to be formed. When the ESCA analysis of this film was carried out, it was found that this film was made of metal ruthenium. This metal ruthenium film had a thickness of 32 nm. This value was obtained by measuring a flat portion excluding the trenches. When the substrate having the ruthenium film was cut in a direction perpendicular to the lengthwise direction of the trenches and its section was observed through a scanning microscope, the ruthenium film was uniformly formed to the insides of the trenches.

A 1. 2 µm-thick copper layer was formed on the ruthenium film of a substrate having trenches and a ruthenium film formed as described above in the same manner as the above performance test as a seed layer described above. The thickness of the copper layer was a value obtained by measuring a flat portion excluding the trenches. When the substrate was cut in the direction perpendicular to the lengthwise direction of the trenches and its section was observed through a scanning electron microscope, no void was seen in the insides of the trenches and trench filling was satisfactory.

### Example 5

### <formation of tungsten layer>

A 4 inch-diameter silicon substrate having a 10 nm-thick tantalum nitride film on one side was prepared as a substrate on which a tungsten film was to be formed. 3 g of tungsten hexacarbonyl was weighed and placed in a quartz boat-like vessel in a nitrogen atmosphere. The quartz vessel was then heated at 180°C. The vapor of the tungsten compound was generated from the heated vessel and brought into contact with the surface of the substrate heated at 250°C to form a silver white film on the substrate. When the ESCA analysis of this film was carried out, it was found that this film was made of metal tungsten. This metal tungsten film had a thickness of 20 nm and a specific resistance of 18 µΩcm.

### <performance test as a seed layer>

The substrate having the tungsten film formed as described above was plated with copper by using a copper sulfate-based electroplating solution at a plating temperature of 18°C and a plating current of 2.83 A for a plating time of 5 minutes to form a 1.2 µm-thick copper layer on the tungsten film. When a cross-cut adhesion test was made on this copper layer in accordance with JIS K5600-5-6, all of the 100 squares were not removed and the adhesion of the copper layer was extremely high.

### <formation of a tungsten film on a trench substrate>

An 8 inch-diameter silicon substrate having a tantalum nitride film with a thickness of 10 nm including the inside of each trench on the surface having linear trenches with a width of 150 nm and a depth of 750 nm (aspect ratio of 5) was prepared.

A silver white film was formed on the substrate in the same manner as the formation of a tungsten film described above except that the above silicon substrate was used as a substrate (first substrate) on which a tungsten film was to be formed. When the ESCA analysis of this film was carried out, it was found that this film was made of metal tungsten. This tungsten film had a thickness of 15 nm (this value was obtained by measuring a flat portion excluding the trenches) . When the substrate having the tungsten film was cut in a direction perpendicular to the lengthwise direction of the trenches and its section was observed through a scanning microscope, the tungsten film was uniformly formed to the insides of the trenches.

A 1.2 µm-thick copper layer was formed on the tungsten film of the substrate having trenches and a tungsten film formed as described above in the same manner as the performance test as a seed layer described above. The thickness of this copper layer was a value obtained by measuring a flat portion excluding the trenches. When the substrate was cut in the direction perpendicular to the lengthwise direction of the trenches and its section was observed through a scanning electron microscope, no void was seen in the insides of the trenches and trench filling was satisfactory.

### Example 6

### <preparation of a substrate and a composition containing a tungsten compound and a solvent>

A 4 inch-diameter silicon substrate having a 10 nm-thick tantalum nitride film on one side was prepared as a substrate (first substrate) on which a tungsten film was to be formed. A 4 inch-diameter silicon substrate was prepared as a second substrate. A solution of 5 g of tungsten hexacarbonyl dissolved in 90 g of methylene chloride was prepared as a composition containing a tungsten compound and a solvent.

The above methylene chloride solution of tungsten hexacarbonyl was applied to one side of the silicon substrate as the second substrate by spin coating in a nitrogen atmosphere and kept at 25°C for 5 minutes to form a 5 µm-thick tungsten compound film.

### <formation of a tungsten film>

Thereafter, the tantalum nitride film side of the first substrate and the tungsten compound film side of the second substrate were opposed to each other at an interval of 1.0 mm in a nitrogen atmosphere. The back of the first substrate was brought into contact with the surface of a hot plate to heat the first substrate at 200°C. The tungsten compound on the second substrate was heated by radiant heat from the heated first substrate to be sublimated, thereby forming a silver white film on the first substrate. When the ESCA analysis of this film was carried out, it was found that this film was made of metal tungsten. This tungsten film had a thickness of 12 nm and a specific resistance of 20 µΩcm.

### <performance test as a seed layer>

The substrate having the tungsten film formed as described above was plated with copper by using a copper sulfate-based electroplating solution at a plating temperature of 18°C and a plating current of 2.83 A for a plating time of 5 minutes to form a 1.2 µm-thick copper layer on the tungsten film. When a cross-cut adhesion test was made on this copper layer in accordance with JIS K5600-5-6, all of the 100 squares were not removed and the adhesion of the copper layer was extremely high.

### <formation of a tungsten film on a trench substrate>

An 8 inch-diameter silicon substrate having a tantalum nitride film with a thickness of 10 nm including the inside of each trench on the surface having linear trenches with a width of 150 nm and a depth of 750 nm (aspect ratio of 5) was prepared.

A silver white film was formed on the first substrate in the same manner as the formation of a tungsten film described above except that the above silicon substrate was used as a substrate (first substrate) on which a tungsten film was to be formed. When the ESCA analysis of this film was carried out, it was found that this film was made of metal tungsten. This tungsten film had a thickness of 15 nm. This value was obtained by measuring a flat portion excluding the trenches. When the substrate having the tungsten film was cut in a direction perpendicular to the lengthwise direction of the trenches and its section was observed through a scanning microscope, the tungsten film was uniformly formed to the insides of the trenches.

A 1.2 µm-thick copper layer was formed on the tungsten film of the substrate having trenches and a tungsten film formed as described above in the same manner as the performance test as a seed layer described above. The thickness of the copper layer was a value obtained by measuring a flat portion excluding the trenches. When the substrate was cut in the direction perpendicular to the lengthwise direction of the trenches and its section was observed through a scanning electron microscope, no void was seen in the insides of the trenches and trench filling was satisfactory.

### Example 7

### <formation of a cobalt/tungsten alloy film>

A 4 inch-diameter silicon substrate having a 10 nm-thick tantalum nitride film on one side was prepared as a substrate on which a cobalt/tungsten alloy film was to be formed. 2 g of tungsten hexacarbonyl and 1.8 g of dicobalt octacarbonyl were weighed and placed in a quartz boat-like vessel in a nitrogen atmosphere. The quartz vessel was then heated at 200°C. The vapor of the cobalt/tungsten compound was generated from the heated vessel and brought into contact with the surface of the substrate heated at 300°C to form a silver white film on the substrate. When the ESCA analysis of this film was carried out, it was found that this film was made of a cobalt/tungsten alloy. This cobalt/tungsten alloy film had a thickness of 26 nm and a specific resistance of 18 µΩcm.

### <performance test as a seed layer>

The substrate having a cobalt/tungsten alloy film formed as described above was plated with copper by using a copper sulfate-based electroplating solution at a plating temperature of 18°C and a plating current of 2.83 A for a plating time of 5 minutes to form a 1. 5 µm-thick copper layer on the cobalt/tungsten alloy film. When a cross-cut adhesion test was made on this copper layer in accordance with JIS K5600-5-6, all of the 100 squares were not removed and the adhesion of the copper layer was extremely high.

### <formation of a cobalt/tungsten alloy film on a trench substrate>

An 8 inch-diameter silicon substrate having a tantalum nitride film with a thickness of 10 nm including the inside of each trench on the surface having linear trenches with a width of 150 nm and a depth of 750 nm (aspect ratio of 5) was prepared.

A silver white film was formed on the substrate in the same manner as the formation of a cobalt/tungsten film described above except that the above silicon substrate was used as a substrate on which a cobalt/tungsten alloy film was to be formed. When the ESCA analysis of this film was carried out, it was found that this film was made of a cobalt/tungsten alloy. This cobalt/tungsten alloy film had a thickness of 24 nm. This value was obtained by measuring a flat portion excluding the trenches. When the substrate having the cobalt/tungsten alloy film was cut in a direction perpendicular to the lengthwise direction of the trenches and its section was observed through a scanning microscope, the cobalt/tungsten alloy film was uniformly formed to the insides of the trenches.

A 1.2 µm-thick copper layer was formed on the cobalt/tungsten alloy film of the substrate having trenches and a cobalt/tungsten alloy film formed as described above in the same manner as the performance test as a seed layer described above. The thickness of this copper layer was a value obtained by measuring a flat portion excluding the trenches. When the substrate was cut in the direction perpendicular to the lengthwise direction of the trenches and its section was observed through a scanning electron microscope, no void was seen in the insides of the trenches and trench filling was satisfactory.

### Example 8

### <preparation of a substrate and a composition containing a cobalt/tungsten alloy compound and a solvent>

A 4 inch-diameter silicon substrate having a 10 nm-thick tantalum nitride film on one side was prepared as a substrate (first substrate) on which a cobalt/tungsten alloy film was to be formed.

A 4 inch-diameter silicon substrate was prepared as a second substrate. A solution of 2.5 g of tungsten hexacarbonyl and 2.0 g of dicobalt octacarbonyl dissolved in 100 g of isopropyl alcohol was prepared as a composition containing a cobalt/tungsten compound and a solvent.

The above isopropyl alcohol solution of the cobalt/tungsten compound was applied to one side of the silicon substrate as the second substrate by spin coating in a nitrogen atmosphere and kept at 25°C for 5 minutes to form a 5 µm-thick cobalt/tungsten compound film.

### <formation of a cobalt/tungsten alloy film>

Thereafter, the tantalum nitride film side of the above first substrate and the cobalt/tungsten alloy compound film side of the second substrate were opposed to each other at an interval of 1.0 mm in a nitrogen atmosphere. The back of the first substrate was brought into contact with the surface of a hot plate to heat the first substrate at 200°C. The cobalt/tungsten alloy compound on the second substrate was heated by radiant heat from the heated first substrate to be sublimated, thereby forming a silver white film on the first substrate. When the ESCA analysis of this film was carried out, it was found that this film was made of a cobalt/tungsten alloy metal. This cobalt/tungsten alloy film had a thickness of 32 nm and a specific resistance of 18 µΩcm.

### <performance test as a seed layer>

The substrate having a cobalt/tungsten alloy film formed as described above was plated with copper by using a copper sulfate-based electroplating solution at a plating temperature of 18°C and a plating current of 2.83 A for a plating time of 5 minutes to form a 1.2 µm-thick copper layer on the cobalt/tungsten alloy film. When a cross-cut adhesion test was made on this copper layer in accordance with JIS K5600-5-6, all of the 100 squares were not removed and the adhesion of the copper layer was extremely high.

### <formation of a cobalt/tungsten alloy film on a trench substrate>

An 8 inch-diameter silicon substrate having a tantalum nitride film with a thickness of 10 nm including the inside of each trench on the surface having linear trenches with a width of 150 nm and a depth of 750 nm (aspect ratio of 5) was prepared.

A silver white film was formed on the first substrate in the same manner as the formation of a cobalt/tungsten alloy film described above except that the above silicon substrate was used as a substrate (first substrate) on which a cobalt/tungsten alloy film was to be formed. When the ESCA analysis of this film was carried out, it was found that this film was made of a cobalt/tungsten alloy metal. This cobalt/tungsten alloy film had a thickness of 29 nm. This value was obtained by measuring a flat portion excluding the trenches. When the substrate having the cobalt/tungsten alloy film was cut in a direction perpendicular to the lengthwise direction of the trenches and its section was observed through a scanning microscope, the cobalt/tungsten alloy film was uniformly formed to the insides of the trenches.

A 1.5 µm-thick copper layer was formed on the cobalt/tungsten alloy film of the substrate having trenches and a cobalt/tungsten alloy film formed as described above in the same manner as the performance test as a seed layer described above. The thickness of the copper layer was a value obtained by measuring a flat portion excluding the trenches. When the substrate was cut in the direction perpendicular to the lengthwise direction of the trenches and its section was observed through a scanning electron microscope, no void was seen in the insides of the trenches and trench filling was satisfactory.

## Claims

1. A method of forming a metal film, comprising the steps of:
sublimating at least one metal compound selected from the group consisting of a cobalt compound, a ruthenium compound and a tungsten compound from a second substrate carrying the above metal compound onto a first substrate for forming a film thereon of at least one metal selected from cobalt, ruthenium and tungsten; and
supplying the sublimated gas to the first substrate to decompose the gas, thereby forming a metal film on the surface of the first substrate.

2. A method of forming a metal film, comprising the steps of:
opposing a first substrate for forming a film thereon of at least one metal selected from the group consisting of cobalt, ruthenium and tungsten to a second substrate having a film of at least one metal compound selected from the group consisting of a cobalt compound, a ruthenium compound and a tungsten compound;
sublimating the metal compound on the second substrate; and
supplying the sublimated gas to the first substrate to decompose the gas, thereby forming a metal film on the surface of the first substrate.

3. A method of forming a metal film, comprising the steps of:
forming a film of at least one metal compound selected from the group consisting of a cobalt compound, a ruthenium compound and a tungsten compound on a substrate for forming a film thereon of at least one metal selected from the group consisting of cobalt, ruthenium and tungsten;
sublimating the metal compound; and
supplying the sublimated gas to a portion different from a portion from which the metal compound has been sublimated of the substrate to decompose the gas, thereby forming a metal film on the surface of the substrate.

4. The method according to any one of claims 1 to 3, wherein the substrate for forming a film thereon of at least one metal selected from the group consisting of cobalt, ruthenium and tungsten has trenches.

5. The method according to any one of claims 1 to 3, wherein at least one metal compound selected from the group consisting of a cobalt compound, a ruthenium compound and a tungsten compound has at least one ligand selected from a CO ligand and a π-coordinate ligand.

6. The method according to any one of claims 1 to 3, wherein the thickness of the formed film of at least one metal selected from the group consisting of cobalt, ruthenium and tungsten is 1 to 1,000 nm.

7. The method according to any one of claims 1 to 3, wherein the formed film of at least one metal selected from the group consisting of cobalt, ruthenium and tungsten is a seed layer for plating.

8. The method according to any one of claims 1 to 3, wherein the film of at least one metal selected from the group consisting of cobalt, ruthenium and tungsten is a film of an alloy of two or more of the above metals.
